Europäisches Patentamt

European Patent Office

Office européen des brevets

(11) Numéro de publication: **0 426 532 A1**

## DEMANDE DE BREVET EUROPEEN

(21) Numéro de dépôt: 90402996.4

(22) Date de dépôt: 24.10.90

(51) Int. Cl.5: **H05K 13/02**

(30) Priorité: 31.10.89 FR 8914299

(43) Date de publication de la demande:
08.05.91 Bulletin 91/19

(84) Etats contractants désignés:
CH DE GB IT LI

(71) Demandeur: **J. LOUPOT S.A.**
**103, Route de Concarneau**
**F-29000 Quimper(FR)**

(72) Inventeur: **Francini, François**
**Cabinet Ballot-Schmit, 7, rue le Sueur**
**F-75116 Paris(FR)**

(74) Mandataire: **Ballot, Paul Denis Jacques et al**
**Cabinet Ballot-Schmit 7, rue le Sueur**
**F-75116 Paris(FR)**

(54) **Machine à préformer les pattes des connexions de composants électriques ou électroniques.**

(57) L'invention concerne une machine à préformer des composants électroniques ou électriques radiaux comprenant un corps et des pattes disposées sur une face de ce corps et dans un même plan, lesdits composants étant stockés en bande.

La machine à préformer est caractérisée en ce qu'elle comprend des moyens d'alimentation (31) de la bande de composants (9) radiaux dans un moyen (10,16) permettant de former sur au moins une patte (9 b) une déformation (38) sans cambrage de celle-ci et un moyen de coupe (25) de l'extrémité des pattes, et en ce qu'elle comprend des moyens (20,27) pour déplacer le moyen de déformation et le moyen de coupe pour régler la position de la déformation (38) et la longueur de coupe des pattes.

FIG. 4

FIG. 3

EP 0 426 532 A1

# MACHINE A PREFORMER LES PATTES DES CONNEXIONS DE COMPOSANTS ELECTRIQUES OU ELEC-TRONIQUES

La présente invention concerne une machine à préformer des composants électriques ou électroniques. Elle se rapporte plus particulièrement à une machine à préformer des composants électriques ou électroniques radiaux. Par composants radiaux, il faut comprendre des composants comprenant un corps et des pattes de connexion disposées sur une face de ce corps et dans un même plan.

Ces composants radiaux sont généralement disposés en bande par collage des pattes sur une bande adhésive. Avant de les fixer sur une plaque de circuit intégré, par exemple, il est nécessaire de former les pattes de connexion à la forme et aux dimensions désirées. Généralement, cette déformation facilite le positionnement du composant sur la plaque, en formant butée ou en formant un logement pour la plaque.

Jusqu'à présent, ces deux étapes pour préformer un composant radial étaient réalisées dans deux machines différentes requérant généralement un démontage de ces machines pour modifier leur réglage.

La présente invention a notamment pour but de remédier à ces inconvénients en proposant une machine à préformer permettant de réaliser la préformation complète des composants avec un réglage aisé et sans démontage des dimensions de coupe ou de la position de la déformation de la patte.

A cet effet, l'invention propose une machine à préformer des composants électroniques ou électriques radiaux comprenant un corps et des pattes disposées sur une face de ce corps et dans un même plan, ces composants étant stockés en bande, caractérisée en ce qu'elle comprend des moyens de déformation permettant de déformer au moins une patte sans cambrage de celle-ci et un moyen de coupe de l'extrémité des pattes.

Cette machine comprend également des moyens pour déplacer respectivement le moyen de déformation et le moyen de coupe pour ainsi permettre le réglage de la position de la déformation et la longueur de coupe des pattes.

Selon une autre caractéristique de l'invention, le moyen de déformation des pattes est constitué par un premier disque formant matrice monté et entraîné en rotation sur un premier axe moteur, et un deuxième disque formant poinçon monté sur un second axe et dont le bord présente une forme conjuguée à celle du bord du premier disque, les bords de chaque disque venant en contact, de manière similaire à des roues d'engrenage.

Dans le mode de réalisation préféré de l'invention, ces deux disques sont montés sur leur axe respectif de manière déplaçable selon la direction longitudinale desdits axes. Ces deux disques sont déplacés solidairement par des moyens de réglage ou déplacement comprenant dans le mode de réalisation préféré de l'invention une vis micrométrique dont le curseur est rendu solidaire de l'un des deux disques par un cavalier. La distance de déplacement des disques peut être déterminée par un vernier associé à la vis micrométrique.

Bien entendu, d'autres systèmes ou dispositifs de déplacement du moyen de déformation peuvent être utilisés sans pour cela sortir du cadre de l'invention. Selon encore une autre caractéristique de l'invention, le moyen de coupe comprend un disque appui monté sur le premier axe moteur et un second disque formant contre-lame monté sur un axe parallèle au premier axe, ces disques étant, dans un mode de réalisation préféré de l'invention déplaçable selon la direction longitudinale des axes.

Comme pour le moyen de déformation, des moyens de déplacement de ce moyen de coupe sont montés sur la machine, et sont constitués, dans un mode de réalisation préféré de l'invention, par une vis micrométrique dont le curseur est rendu solidaire d'au moins l'un des deux disques par un cavalier. La position de ce moyen de coupe peut également être déterminée et ajustée par un vérin associé à la vis micrométrique.

Ainsi, par simple actionnement des vis micrométriques, il est possible de régler la position de la déformation et la longueur de coupe sans avoir à effectuer un démontage de la machine.

Dans un mode de réalisation préféré de l'invention, les moyens d'alimentation de la bande de composants radiaux comprend un disque d'entraînement monté de manière fixe sur le premier axe moteur et muni de picots coopérant avec les perforations de la bande papier.

Selon une caractéristique préférée de l'invention, le disque formant contre-lame du moyen de coupe est·monté sur le second axe portant le disque poinçon du moyen de déformation.

Selon une autre caractéristique de l'invention, le disque formant matrice comprend sur son bord une gorge avec une section correspondant à la déformation désirée de la patte, le disque poinçon comprenant sur son bord une nervure de section conjuguée à la gorge du disque matrice.

Toutefois, la forme des bords des disques matrice·et poinçon est adaptée à la forme désirée de la déformation et au nombre de pattes d'un composant que l'on veut déformer.

Ainsi, il est possible avec la machine de l'invention de provoquer une déformation d'une patte au-dessous du plan formé par les pattes, et sur la suivante former une déformation au-dessus dudit plan. Il est également possible de déformer une patte sur deux ou trois, selon le nombre de pattes que porte le composant.

D'autres buts, caractéristiques et avantages de l'invention apparaîtront plus clairement au vu de la description détaillée d'un mode de réalisation d'une machine conforme à l'invention faite en référence aux figures annexées données uniquement à titre d'exemple, et dans lesquelles :

- la figure 1 représente une vue schématique en coupe longitudinale partielle d'un mode de réalisation d'une machine conforme à l'invention,

- la figure 2 représente une vue schématique de dessous de la machine de la figure 1,

- la figure 3 représente une vue schématique de côté de la machine de la figure 1,

- la figure 4 est un schéma explicatif illustrant le positionnement des composants électriques sur la bande adhésive et la déformation des pattes, et

- la figure 5 illustre le positionnement des composants électroniques sur une plaque de circuit imprimé.

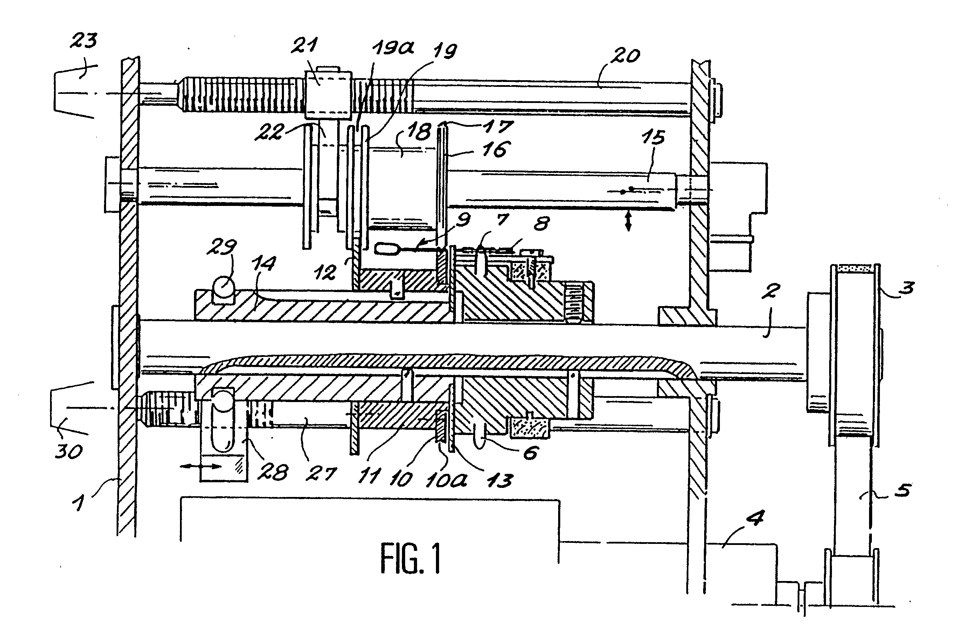

En se référant à la figure 1, un mode de réalisation d'une machine à préformer sera décrite à titre d'exemple et d'illustration.

Cette machine comprend un châssis 1, un premier axe 2 solidaire d'une poulie 3. Cette poulie est entraînée en rotation, par exemple par un moteur électrique 4 et une courroie 5.

Sur cet axe 2 est monté, solidaire en rotation, un premier disque 6 comprenant sur son bord des picots 7 permettant d'entraîner une bande 8 de composants électroniques 9.

Un disque 10 est également monté, solidaire en rotation, sur le premier axe 2 au moyen d'une douille 11. L'autre extrémité de la douille 11 comprend un disque 12.

Le disque 10 comprend sur son bord une rainure 10a constituant la matrice pour former les déformations sur les pattes de composants 9.

Sur ce premier axe 2 est également monté un disque 13 formant la contre-lame des moyens de coupe. Ce disque est également monté solidaire en rotation au moyen d'une douille 14.

Ainsi, les douilles 11,14 permettent de déplacer respectivement les disques 10 et 13 selon la direction longitudinale de l'axe 2.

La machine comprend un second axe 15 parallèle au premier axe 2, sur lequel est monté solidaire en rotation un disque 16 dont le bord comprend une nervure 17 de forme conjuguée à la gorge 10a du disque 10.

Le disque 16 est positionné de telle manière que la nervure 17 vient en contact avec la gorge 10a du disque pour ainsi former le poinçon permettant de déformer les pattes du composant électronique.

Le disque 16 est monté sur l'axe 15 au moyen d'une douille 18 comprenant à son autre extrémité un disque 19. Le disque 19 comprend sur son bord un logement 19a dans lequel vient pénétrer le disque pour ainsi rendre solidaire en déplacement longitudinal les disques 17 et 10.

Le déplacement longitudinal des disques 17 et 10, formant le moyen de déformation, est assuré dans le mode de réalisation représenté, par une vis micrométrique 20 munie d'un curseur 21 connecté par un cavalier 22 à la douille 18. Cette vis micrométrique 20 est actionnée par un vernier 23 qui peut permettre d'afficher la position, de la déformation par rapport à une référence, par exemple le disque d'entraînement 13.

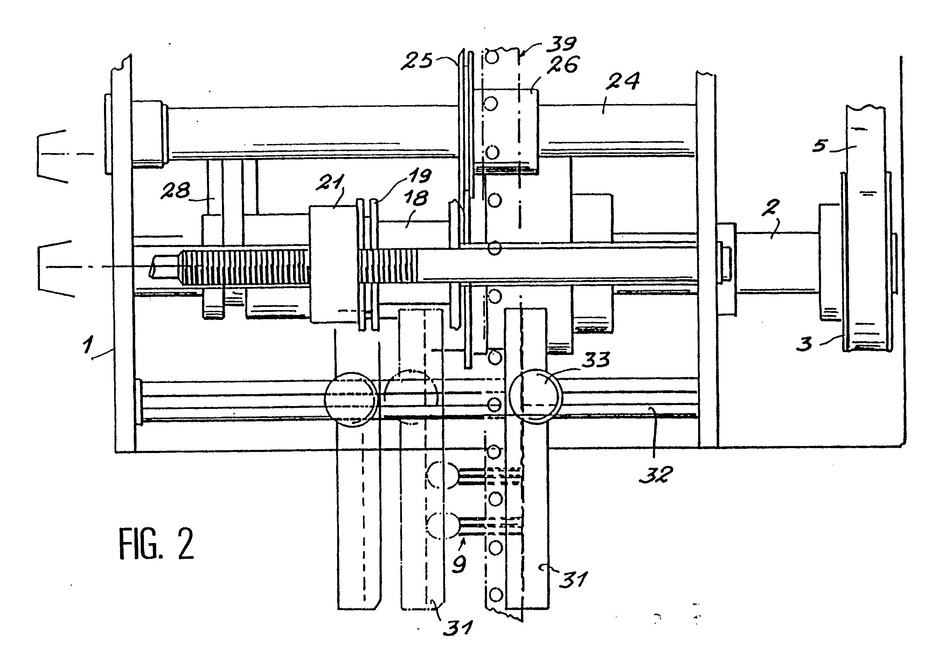

La machine comprend un troisième axe 24, illustré sur la figure 2, sur lequel est monté un disque 25 formant contre-lame et coopérant avec le disque 13. L'ensemble, disque 25 et disque 13, forme le moyen de coupe des pattes des composants 9. Le disque 25 est monté sur l'axe 24 au moyen d'une douille 26 pour permettre un déplacement longitudinal du disque.

Les disques 25 et 13 sont déplacés selon la direction longitudinale des axes 2 et 24 au moyen d'une vis micrométrique 27 (figure 1). Le curseur 28 de cette vis micrométrique est relié à la douille 14 du disque 13 par un cavalier 29. Cette vis est actionnée par un vernier 30 permettant d'afficher la longueur de coupe des pattes.

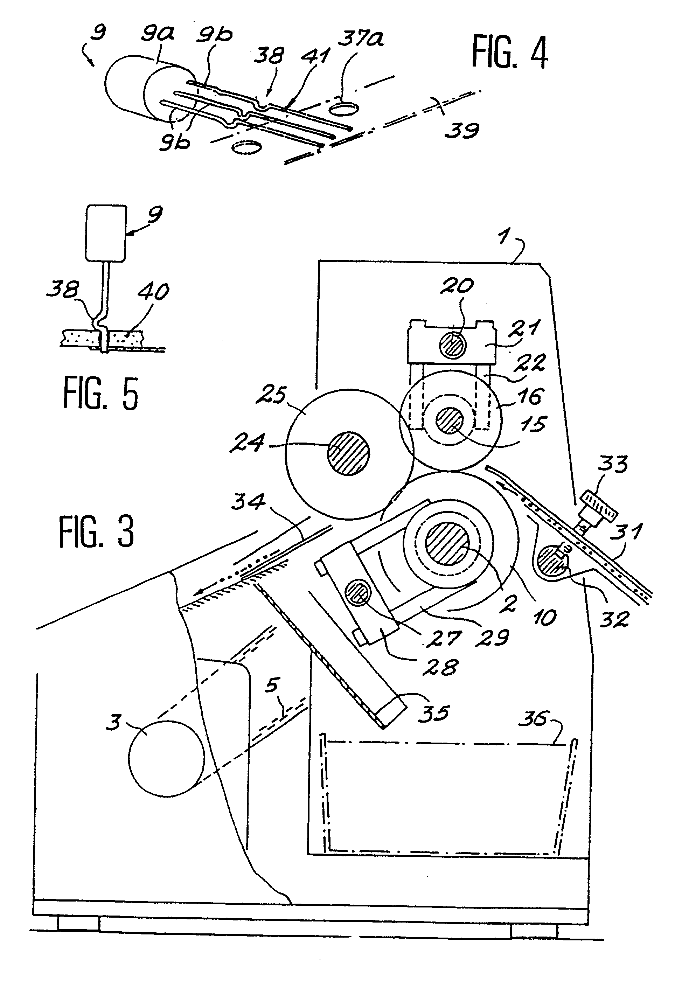

La position des différents axes 2, 15 et 24 est clairement illustrée à la figure 3.

La machine comprend des moyens d'alimentation de la bande des composants 9 constitués, dans le mode de réalisation illustré, par un guide de bande 31 (figures 2 et 3) qui est monté de manière réglable sur un axe support 32. La position du guide 31 est fixée par une vis 33.

La machine comprend également une goulotte 34 pour évacuer les déchets de coupe et la bande de papier, ainsi qu'une goulotte 35 pour recueillir et canaliser les composants préformés dans un récipient collecteur 36.

Le fonctionnement de la machine de l'invention sera maintenant décrite.

Les figures 4 et 5 illustrent un composant électronique ou électrique 9 axial qui peut être préformé par la machine de l'invention. Ainsi, ce composant 9 comprend un corps 9a et des pattes 9b qui sont disposées sur une seule face du corps 9a et dans un même plan. Ces composants sont disposés en bande par collage de l'extrémité des pattes 9b sur une bande de papier 37 munie de perforations 37a.

Comme illustré aux figures 4 et 5, la machine de l'invention permet de déformer les pattes 9b pour former une courbure 38, par exemple en forme de U, et couper les pattes en 41.

Cette préformation des pattes facilite le positionnement des composants 9 sur une plaque 40 de circuit imprimé comme illustré à la figure 5 et ainsi permettre une fixation correcte de ces composants.

Cette préformation est réalisée par alimentation de la bande de composants 9 dans le guide 31. Cette bande est ensuite entraînée par le disque 6 amenant les pattes 9b entre les disques 10 et 16 provoquant ainsi la déformation des pattes. Les composants sont ensuite amenés entre les disques 13 et 25 pour les couper à la longueur désirée. Les composants ainsi préformés sont recueillis dans le récipient 36.

Il est aisément compréhensible que la position de la déformation et la longueur de coupe sont facilement réglables par simple actionnement des verniers 23 et 30. Par ailleurs, le débit de la machine peut être réglé par réglage de la vitesse du moteur d'entraînement de l'axe 2.

En outre, la forme de la déformation peut être modifiée par utilisation des disques 10, 16 comprenant des bords conformés à la forme désirée, notamment le disque 10 formant matrice comprend sur son bord, de manière alternée, une gorge et une nervure, le disque 16 formant poinçon ayant un bord de forme conjuguée.

**Revendications**

1. Machine à préformer des composants électroniques ou électriques radiaux comprenant un corps et des pattes disposées sur une face de ce corps et dans un même plan, lesdits composants étant stockés en bande, caractérisée sen ce qu'elle comprend des moyens d'alimentation (6,31) de la bande de composants (9) radiaux dans un moyen (10,16) permettant de former sur au moins une patte (9 b) une déformation (38) sans cambrage de celle-ci et un moyen de coupe (13,25) de l'extrémité des pattes, et en ce qu'elle comprend des moyens (20,27) pour déplacer le moyen de déformation et le moyen de coupe pour régler la position de la déformation (38) et la longueur de coupe des pattes.

2. Machine selon la revendication 1, caractérisée en ce que le moyen de déformation des pattes (9b) est constitué par un premier disque (10) monté et entraîné en rotation sur un premier axe (2) moteur, et un deuxième disque (16) monté sur un second axe (15), les bords de chaque disque venant en regard de l'autre disque, la configuration du bord du premier disque (10) étant conjuguée à celle du second disque (16) pour ainsi former une matrice tandis que le bord du second disque joue le rôle du poinçon.

3. Machine selon la revendication 2, caractérisée en ce que le moyen de coupe comprend un disque d'appui (13) monté sur le premier axe (2) précité et un second disque associé (25) formant contre-lame monté sur un troisième axe (24).

4. Machine selon la revendication 3, caractérisée en ce que les disques (10,16) du moyen de déformation et les disques (13,25) du moyen de coupe sont déplaçables selon la direction longitudinale des premier (2), second (15) et troisième axes (24).

5. Machine selon l'une des revendications 3 ou 4, caractérisée en ce que le disque formant contre-lame (25) du moyen de coupe est monté sur le troisième axe (15) précité.

6. Machine selon l'une des revendications 2 à 5, caractérisée en ce que les moyens d'alimentation de la bande des composants comprennent un disque d'entraînement (7) monté solidaire en rotation sur le premier axe (2).

7. Machine selon l'une des revendications 4 à 6, caractérisée en ce qu'elle comprend un moyen (20) pour déplacer selon la direction longitudinale des axes (2,15,24) les deux disques (10,16) formant le moyen de déformation, et un second moyen (27) pour déplacer les disques (13,25) formant le moyen de coupe.

8. Machine selon la revendication 7, caractérisée en ce que ces deux moyens de déplacement sont constitués par un système de vis micrométrique (20,27) dont le curseur (21,28) est rendu solidaire du moyen de déformation ou du moyen de coupe par des cavaliers (22,29).

9. Machine selon l'une des revendications 2 à 8 caractérisée en ce que le disque (10) formant matrice du moyen de déformation comprend sur son bord une gorge (10a), le disque (16) formant poinçon comprend sur son bord une nervure (17) de forme conjuguée.

10. Machine selon l'une des revendications 2 à 8, caractérisée en ce que le disque (10) formant matrice du moyen de déformation comprend sur son bord de manière alternée une gorge et une nervure, le disque (16) formant poinçon ayant un bord de forme conjuguée.

FIG. 1

EP 0 426 532 A1

FIG. 2

EP 0 426 532 A1

FIG. 4

FIG. 5

FIG. 3

7

Office européen des brevets

# RAPPORT DE RECHERCHE EUROPEENNE

Numero de la demande

EP 90 40 2996

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | EP-A-145301 (FRANK STORIMANS LIMITED)<br>* page 8, lignes 5 - 18; figures 1, 5 *<br>* abrégé *<br>--- | 1 | H05K13/02 |
| A | GB-A-2062514 (THOMAS WERESCH)<br>* page 1, lignes 1 - 17; figures 1, 2 *<br>* page 3, ligne 53 - page 4, ligne 30 *<br>--- | 1 | |
| A | DE-A-2910633 (THOMAS WERESCH)<br>* page 17, alinéa 2 - page 19; revendication 1; figures 1, 2, 5 *<br>----- | 1 | |

|  | DOMAINES TECHNIQUES RECHERCHES (Int. Cl.5) |
|---|---|
|  | H05K<br>B21D |

Le présent rapport a été établi pour toutes les revendications

| Lieu de la recherche | Date d'achèvement de la recherche | Examinateur |
|---|---|---|
| BERLIN | 13 FEVRIER 1991 | CLOSA, D |